# EUROPÄISCHE PATENTSCHRIFT

(11) **EP 2 627 974 B1**
(45) Veröffentlichungstag und Bekanntmachung des Hinweises auf die Patenterteilung: **25.04.2018**
(21) Anmeldenummer: 11784414.2
(22) Anmeldetag: 12.10.2011
(51) Int. Cl.: G01D 5/244, G01R 19/00, G01R 31/02, G01R 31/28

(54) **VERFAHREN, SCHALTUNGSANORDNUNG UND ÜBERWACHUNGSVORRICHTUNG ZUR SIGNALPRÜFUNG**
METHOD, CIRCUIT ARRANGEMENT AND MONITORING DEVICE FOR SIGNAL TESTING
PROCÉDÉ, CIRCUIT ET DISPOSITIF DE SURVEILLANCE POUR CONTRÔLER DES SIGNAUX

(30) Priorität: 13.10.2010 DE 102010048186
(43) Veröffentlichungstag der Anmeldung: 21.08.2013
(73) Patentinhaber: Phoenix Contact GmbH & Co. KG, 32825 Blomberg (DE)
(72) Erfinder: TEUTENBERG, Jürgen, 59602 Rüthen (DE)
(74) Vertreter: Blumbach · Zinngrebe Patent- und Rechtsanwälte
(86) Internationale Anmeldenummer: PCT/EP2011/005106
(87) Internationale Veröffentlichungsnummer: WO 2012/059169

(56) Entgegenhaltungen:
- EP-A2- 1 314 965
- DE-A1- 4 428 673

## Beschreibung

Die Erfindung betrifft allgemein die analoge Schaltungstechnik und insbesondere die Prüfung korrelierter Signale mit Hilfe analoger Schaltungen.

Es können viele mathematische Funktionen in reiner Analogtechnik leicht aufgebaut werden, wenn Operationsverstärker zum Einsatz kommen. Speziell die Umsetzung der Funktion x² ist jedoch sehr aufwändig.

Eine solche Anforderung besteht aber beispielsweise bei der Überwachung von Signalen eines Inkrementalencoders oder Inkrementalgebers mit einem analogen sin/cos-Ausgangssignal, da diese Überwachung vorteilhaft durch eine auf der Gleichung sin²x+cos²x=1 basierenden Prüfung erfolgt. Das Signal eines sin/cos-Inkrementalencoders ist zweispurig und folgendermaßen konzipiert: Eine Signalspur A liefert ein kontinuierliches Sinussignal, dessen Frequenz von der Rotationsgeschwindigkeit des Inkrementalencoders abhängt. Die Signalspur B liefert ein analoges Signal wie Spur A - jedoch um 90° phasenverschoben - also das Cosinussignal. Einige Encoder liefern A und B jeweils als Differenzsignal, welches mittels einer Vorverarbeitung, beispielsweise unter Verwendung eines Differenzverstärkers so vorverarbeitet werden kann, dass am Ausgang der Vorverarbeitung je Spur jeweils nur noch das oben beschriebene Signal bereitsteht.

Eine Überwachungseinheit zur Prüfung des Encodersignals auf Fehler prüft kontinuierlich die Gleichung A²+B²=1 mit A=sin(x) für Spur A und mit B=cos(x) für Spur B, und nutzt dabei die durch die Gleichung sin²x+cos²x=1 definierte bei Normalbetrieb bestehende Abhängigkeit der Signale A und B aus. Eine solche Überwachungseinheit wird zum Beispiel im Bereich der Sicherheitstechnik eingesetzt, um eine Prüfung auf Fehler, wie Unterbrechung in Spur A oder B, Kurzschlüsse der Spuren zu Masse oder zur Versorgungsspannung oder Querschlüsse zwischen den Signalspuren A und B, durchzuführen.

Eine solche Überwachungseinheit lässt sich leicht mit Hilfe eines Mikrocontrollers mit analogen Eingängen und entsprechender Software realisieren. Bei Anwendungen, in denen ein Mikrocontroller nicht zur Verfügung steht oder in denen aus Kostengründen auf einen solchen verzichtet werden soll, lässt sich die beschriebene Signalprüfung alternativ auch mit Analogtechnik umsetzen. Bei Ausführung in Analogtechnik besteht jedoch das oben genannte Problem, dass die Umsetzung quadratischer Terme einen sehr hohen schaltungstechnischen Aufwand erfordert.

In EP 1 314 965 A2 wird eine Kontrollvorrichtung einer Positionsmesseinrichtung zur Kontrolle der Amplitudenhöhe gegeneinander phasenverschobener periodischer Abtastsignale S1 bis S4 beschrieben, wobei die Kontrollvorrichtung ein Detektormittel zur Bestimmung der Amplitudenhöhe der Abtastsignale S1 bis S4 und Erzeugung eines davon abhängigen Amplitudensignals A, ein Mittel zur Bildung eines Abweichungssignals B durch Vergleich des Amplitudensignals A mit einem vorgegebenen Sollsignal F, eine Bewertungseinrichtung, um das Abweichungssignal B unterschiedlich zu wichten, sowie ein Hinweismittel zum Vorsehen eines Hinweises in Abhängigkeit vom gewichteten Abweichungssignal BG aufweist. Das Detektormittel umfasst einen Multiplexer, welcher aus den Abtastsignalen S1 bis S4 jeweils das mit maximaler Amplitude selektiert und diese selektierten Abtastsignale S1 bis S4 zu einer Hüllkurve zusammensetzt, welche das Amplitudensignal A bildet. Diese Art der Erzeugung des Amplitudensignals bietet gegenüber der Alternative, es rechnerisch durch A = S1² + S2² zu bilden, den Vorteil, dass auf diese Weise auf einen ansonsten erforderlichen Prozessor verzichtet werden kann.

In DE 44 28 673 A1 wird eine Vorrichtung zur Bildung einer Steuergröße beschrieben, welche ein Maß für die Amplitude zweier frequenz- und amplitudengleichen, phasenstarren sinus- und cosinusförmigen Meßwechselgrößen ist, welche ein Diodennetzwerk und eine nachgeschaltete Summierverstärkerschaltung umfasst. Dem Diodennetzwerk werden die Meßwechselgrößen und deren Inversionen als Verarbeitungsgrößen zugeführt und die von den Verarbeitungsgrößen im Diodennetzwerk hervorgerufenen Teilströme werden durch die Summierverstärkerschaltung zur Steuergröße zusammengefasst. Die schaltungstechnische Auslegung wird derart gewählt, dass die im Diodennetzwerk auftretenden Teilströme einen Arbeitspunkt im Krümmungsbereich der Kennlinie der jeweiligen Dioden hervorrufen, so dass die Teilströme vorteilhaft näherungsweise quadriert werden, so dass die mathematische Beziehung A+B²=a² mit einer in der Praxis ausreichenden Genauigkeit nachgebildet wird.

Der Erfindung liegt daher die Aufgabe zugrunde, einen neuen und/oder verbesserten Weg zur Signalprüfung, insbesondere unter Verwendung analoger Schaltungstechnik, aufzuzeigen. Eine weitere Aufgabe der Erfindung besteht insbesondere darin, einen Weg zur Fehlerprüfung von Signalen aufzuzeigen, die von einer elektrischen Vorrichtung bereitgestellt werden und die im Normalbetrieb der elektrischen Vorrichtung auf bekannte Weise voneinander abhängen.

Diese Aufgabe wird durch ein Verfahren gemäß Anspruch 1, sowie durch eine Schaltungsanordnung gemäß Anspruch 6 und eine Überwachungsvorrichtung gemäß Anspruch 11 gelöst.

Vorteilhafte Ausführungsformen und Weiterbildungen sind in den jeweiligen Unteransprüchen angegeben.

Eine regelmäßige Anforderung beim Betrieb elektrischer Vorrichtungen besteht darin, erzeugte Signale zur Fehlererkennung zu prüfen. Bei bestimmten Anwendungen stehen Signale zur Verfügung, die im Normalbetrieb auf bestimmte Weise voneinander abhängen. Beispielsweise bei den von einem Inkrementalencoder bereitgestellten Signalspuren handelt es sich um ein Sinus-Signal und das dazu um 90° phasenverschobene Cosinus-Signal. Aufgrund der mathematischen Beziehung sin²x+cos²x=1 weist die Summe der Quadrate der Signalwerte der beiden Signalspuren einen zeitlich konstanten Wert auf. Ein Fehler kann somit in an sich bekannter Weise dadurch erkannt werden, dass ein mittels einer definierten Berechnungsvorschrift ermittelter Prüfwert, hier die Summe der Quadrate der Signalwerte der beiden Signalspuren, von dem bekannten konstanten Vergleichswert abweicht.

Soll für die Prüfung eine analoge Schaltung eingesetzt werden, muss bei dem beschriebenen Beispiel eines Inkrementalencoders zum Erzeugen eines entsprechenden analogen Prüfsignals eine Signalquadrierung durch analoge Schalttechnik abgebildet werden, was schaltungstechnisch sehr aufwändig ist.

Ein Kerngedanke der Erfindung besteht darin, für die Fehlerprüfung von im Normalbetrieb einer elektrischen Vorrichtung auf bekannte Weise voneinander abhängende Signale eine alternative Berechnungsvorschrift anzuwenden, die einen Prüfwert liefert, der nicht zeitlich konstant ist, sondern zeitlich innerhalb eines bekannten Wertebereiches schwankt.

Die Verwendung einer solchen alternativen Berechnungsvorschrift hat den Nachteil, dass aufgrund des zulässigen Wertebereiches des Prüfwertes ein Fehler, der nur zu einer kleinen Änderung der zu prüfenden Signale führt, möglicherweise nicht erkannt wird, da der Prüfwert trotz des aufgetretenen Fehlers noch innerhalb des zulässigen Wertebereiches liegt. Der besondere Vorteil liegt aber darin, dass die alternative Berechnungsvorschrift so gewählt werden kann, dass eine einfache Umsetzung in analoger Schalttechnik möglich ist. Ein Kerngedanke der Erfindung sieht somit vor, auf Kosten der Genauigkeit der Fehlerprüfung den erforderlichen Schaltungsaufwand zu reduzieren.

Dementsprechend sieht ein erfindungsgemäßes Verfahren vor, zur Signalprüfung wenigstens eines ersten und zweiten analogen Eingangssignals, welche von einer elektrischen Vorrichtung bereitgestellt werden und welche im Normalbetrieb der Vorrichtung derart voneinander abhängen, dass ein mittels einer vorgegebenen ersten Vorschrift aus dem wenigstens einen ersten und zweiten analogen Signal ermittelbares erstes Ausgangssignal im Wesentlichen zeitlich konstant ist, eine zweite Vorschrift zum Ermitteln eines zweiten Ausgangssignals aus dem wenigstens einen ersten und zweiten analogen Eingangssignal zu definieren, wobei das zweite Ausgangssignal zeitlich innerhalb eines vorgegebenen Wertebereiches schwankt. Das Verfahren sieht weiter vor, eine analoge Schaltungsanordnung bereitzustellen, welche die zweite Vorschrift abbildet und wenigstens einen ersten Signaleingang für das erste und einen zweiten Signaleingang für das zweite analoge Eingangssignal aufweist, sowie einen Ausgang zum Bereitstellen des auf Basis der zweiten Vorschrift durch die Schaltungsanordnung erzeugten Ausgangssignals. Ferner sieht das Verfahren vor, das wenigstens eine erste und zweite analoge Eingangssignal den zugeordneten Signaleingängen der bereitgestellten Schaltungsanordnung zuzuführen und das Ausgangssignal auszuwerten. Ergibt die Auswertung, dass das am Ausgang der Schaltungsanordnung anliegende Ausgangssignal innerhalb des vorgegebenen Wertebereiches liegt, so wird ein positives Prüfungsergebnis der Signalprüfung bereitgestellt, andernfalls wird ein negatives Prüfungsergebnis bereitgestellt.

Besonders vorteilhaft lässt sich das Verfahren einsetzen, wenn die erste Vorschrift eine Berechnungsvorschrift ist, welche wenigstens einen quadratischen Term umfasst, da in diesem Fall der schaltungstechnische Aufwand ohne Einsatz der Erfindung besonders hoch ist, also ein hohes Maß an schaltungstechnischer Vereinfachung erzielt werden kann. Dementsprechend ist die zweite Vorschrift vorzugsweise eine Berechnungsvorschrift, welche keinen quadratischen Term umfasst.

In einer besonders vorteilhaften Ausführungsform ist die erste Vorschrift die Berechnungsvorschrift f₁(A,B)=A²+B² und die zweite Vorschrift ist die Berechnungsvorschrift f₂(A,B)=|A|+|B|, wobei A das erste Eingangssignal und B das zweite Eingangssignal bezeichnen.

Die Berechnungsvorschrift f₂(A,B)=|A|+|B| lässt sich beispielsweise vorteilhaft in einer bevorzugten Ausführungsform verwenden, bei welcher im Normalbetrieb der elektrischen Vorrichtung das erste Eingangssignal ein Sinus-Signal und das zweite Eingangssignal ein dazu um 90° phasenverschobenes Cosinus-Signal ist, wobei solche erste und zweite Eingangssignale beispielsweise von einem Inkrementalgeber bereitgestellt werden.

Einige Encoder liefern A und B jeweils indirekt als Differenzsignal je zweier Signale A₁ und A₂ bzw. B₁ und B₂ mit A=A₁-A₂ und B=B₁-B₂, so dass durch solche Encoder zwei erste und zwei zweite Eingangssignale bereitgestellt werden. In dieser Ausführungsform ist die erste Vorschrift vorteilhaft die Berechnungsvorschrift f₁(A₁,A₂,B₁,B₂)=(A₁-A₂)²+(B₁-B₂)² und die zweite Vorschrift ist die Berechnungsvorschrift f₂(A₁,A₂,B₁,B₂) = |A₁-A₂|+|B₁-B₂|.

Eine erfindungsgemäße Schaltungsanordnung zum Erzeugen eines Prüfsignals aus wenigstens einem ersten und einem zweiten von einer elektrischen Vorrichtung bereitgestellten analogen Eingangssignals ist dazu ausgebildet, ein Prüfsignal zu erzeugen, welches im Normalbetrieb der elektrischen Vorrichtung zeitlich innerhalb eines vorgegebenen Wertebereiches schwankt.

Vorteilhaft hängen das erste und zweite Eingangssignal im Normalbetrieb der elektrischen Vorrichtung derart voneinander ab, dass ein mittels einer vorgegebenen ersten Vorschrift aus den wenigstens zwei analogen Signalen ermittelbares erstes Ausgangssignal im Wesentlichen zeitlich konstant ist.

In einer vorteilhaften Ausführungsform, die beispielsweise zur Signalprüfung zweier Signalspuren eines Inkrementalgebers geeignet ist, ist im Normalbetrieb der elektrischen Vorrichtung das erste Eingangssignal ein Sinus-Signal und das zweite Eingangssignal ein dazu um 90° phasenverschobenes Cosinus-Signal.

Besonders vorteilhaft ist die Schaltungsanordnung als analoge Schaltung aufgebaut, die ausschließlich Bauteile der analogen Schalttechnik umfasst. Erfindungsgemäß umfasst die Schaltungsanordnung einen ersten Schaltungsteil, welcher zum Addieren der positiven Spannungsanteile des ersten und zweiten Eingangssignals ausgebildet ist, einen zweiten Schaltungsteil, welcher zum Addieren der negativen Spannungsanteile des ersten und zweiten Eingangssignals ausgebildet ist, und einen mit dem ersten und zweiten Schaltungsteil verbundenen dritten Schaltungsteil zum Ermitteln der Differenz der addierten positiven und der addierten negativen Spannungsanteile, wobei der dritte Schaltungsteil ausgangsseitig das Prüfsignal bereitstellt. Das Addieren der negativen Spannungsanteile des ersten und zweiten Eingangssignals entspricht dem Addieren der positiven Spannungsanteile der invertierten Eingangssignale. Diese Schaltungsanordnung bildet die oben beschriebene Berechnungsvorschrift f₂(A,B)=|A|+|B| ab, wobei A das erste Eingangssignal und B das zweite Eingangssignal bezeichnen. In einer weiteren bevorzugten Ausführungsform, in welcher ein Encoder entsprechende Signale A und B jeweils als Differenzsignal je zweier Signale A₁ und A₂ bzw. B₁ und B₂ mit A=A₁-A₂ und B=B₁-B₂ bereitstellt, bildet die Schaltungsanordnung vorteilhaft die Berechnungsvorschrift f₂(A₁,A₂,B₁,B₂)=|A₁-A₂|+|B₁-B₂| ab. Die Schaltungsanordnung ist in dieser Ausführungsform wie oben beschrieben aufgebaut, wobei jeweils vor dem ersten und zweiten Schaltungsteil ein Vorverarbeitungs-Schaltungsteil angeordnet ist, welcher beispielsweise jeweils einen Differenzverstärker umfasst.

Die der Erfindung zugrundeliegende Aufgabe wird auch durch eine Überwachungsvorrichtung gelöst, welche eine analoge Schaltungsanordnung wie oben beschrieben zum Erzeugen eines ersten Prüfsignals aus einem ersten und einem zweiten von einer elektrischen Vorrichtung erzeugten Eingangssignal umfasst, sowie eine Überwachungseinheit zum Überwachen des ersten Prüfsignals, wobei die Überwachungseinheit dazu ausgebildet ist, ein Fehlersignal zu erzeugen, wenn das erste Prüfsignal einen Signalwert aufweist, der außerhalb eines vorgegebenen Wertebereiches liegt.

Zu diesem Zweck ist die Überwachungseinheit vorteilhaft dazu ausgebildet, das erste Prüfsignal mit einem unteren und/oder einem oberen Schwellwert zu vergleichen.

Die Überwachungsvorrichtung kann vorteilhaft zur Überwachung von Signalen eingesetzt werden, welche im Normalbetrieb auf bekannte Weise voneinander abhängen.

In der Sicherheitstechnik werden Überwachungseinrichtungen häufig mehrkanalig und möglichst diversitär aufgebaut. Dementsprechend umfasst die Überwachungsvorrichtung vorteilhaft ferner eine digitale Schaltung zum Erzeugen eines zweiten Prüfsignals aus dem ersten und zweiten Eingangssignal. Auf diese Weise kann eine diversitäre

Überwachungsvorrichtung bereitgestellt werden, bei welcher ein Überwachungskanal beispielsweise mit einem Mikrocontroller realisiert ist und ein zweiter Überwachungskanal mit einer analogen Schaltung wie oben beschrieben arbeitet. Die Erfindung wird nachfolgend beispielhaft anhand bevorzugter Ausführungsformen und unter Bezugnahme auf die beigefügten Zeichnungen genauer beschrieben. Dabei bezeichnen gleiche Bezugszeichen in den Zeichnungen gleiche oder ähnliche Teile.

Es zeigen:
- Fig. 1:: ein schematisches Schaltbild einer bevorzugten Ausführungsform einer erfindungsgemäßen Schaltungsanordnung, und
- Fig. 2:: schematisch den Signalverlauf der Eingangssignale und des Ausgangssignals der Schaltungsanordnung in Fig. 1 bei Normalbetrieb der Vorrichtung, welche die Eingangssignale bereitstellt.

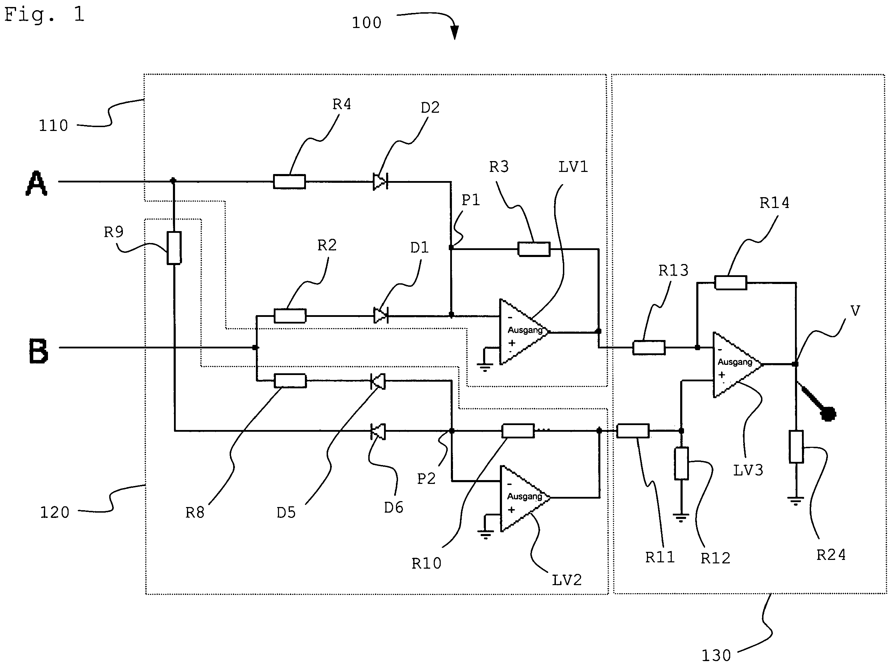

In Fig. 1 ist ein Schaltbild einer bevorzugten Ausführungsform einer erfindungsgemäßen Schaltungsanordnung 100 dargestellt. Diese weist die Signaleingänge A und B auf, um der Schaltungsanordnung die Signalspuren eines Signalgebers zuzuführen. Die Schaltungsanordnung dient dazu, aus diesen Eingangssignalen ein Prüfsignal zu erzeugen, welches dazu verwendet werden kann, die Eingangssignale auf Fehler zu prüfen, welche beispielsweise durch eine Unterbrechung in Spur A oder B, einen Kurzschluss einer Spur zu Masse oder zur Versorgungsspannung oder Querschlüsse zwischen den Signalspuren A und B verursacht werden können.

Die in Fig. 1 dargestellte Schaltungsanordnung dient dazu, statt wie bekannt eine Prüfung der Signalspuren A und B basierend auf der Funktion A²+B²=1 durchzuführen, die Funktion F = |A|+|B| abzubilden. Da im Normalbetrieb des Inkrementalgebers ein Zusammenhang zwischen A und B besteht, da A=sin(x) und B=cos(x), liefert die Funktion |A|+|B| immer einen Ergebniswert im Intervall zwischen 1,0 und 1,41 für jeden Wert von x.

Die bekannte, auf der Gleichung A²+B²=1 basierende Berechnung wird ersetzt durch eine Kontrolle der Gleichung |A|+|B| = 1,2 - aufgrund der Vereinfachung liefert das Ausgangssignal nicht 1,0 mit 0% Toleranz sondern 1,2 mit 18% Toleranz als Ergebnis. Zusätzlich sind in der Regel übliche Toleranzen der Eingangssignale zu berücksichtigen, so dass in der Regel höhere Schwankungen am Ausgang als die genannten 18% zugelassen sind, ohne dass ein negatives Prüfungsergebnis der Signalprüfung bereitgestellt bzw. ein Fehler erkannt wird. Dies ist jedoch für die Fehlererkennung im dargestellten Beispiel eines Inkrementalencoders unproblematisch, da eine Überwachung des Encodersignals in der Regel nur auf grobe Abweichungen ausgelegt sein muss.

Die Aufgabe der Kontrolle der Gleichung |A|+|B| = 1,2 mit 18% Toleranz für zwei Eingangssignale A und B lässt sich umformulieren in die Aufgabe der Kontrolle der Gleichung max(A;0)-min(A;0)+max(B;0)-min(B;0) = 1,2 mit 18% Toleranz. Mit der Funktion J=max(A;0)+max(B;0) und der Funktion K=min(A;0)+min(B;0) ergibt sich die Kontrolle der Gleichung J-K=1,2 mit 18% Toleranz.

Diese Funktion wird durch die in Fig. 1 dargestellte Schaltungsanordnung unter Verwendung von Operationsverstärkern LV1, LV2 und LV3 umgesetzt, wobei LV1 und LV2 als Summierverstärker und LV3 als Differenzverstärker wirken. Alternativ können auch andere Bausteine als Operationsverstärker eingesetzt werden.

Das Berechnungsergebnis liegt am Punkt V vor. Der rechte Schaltungsteil 130 ab R13, R11 ist ein Differenzverstärker, welcher praktisch die Funktion F=J-K berechnet. Der verbleibende linke Schaltungsteil kann von der Betrachtung her in einen oberen Schaltungsteil 110 und einen unteren Schaltungsteil 120 aufgeteilt werden. Der obere Schaltungsteil 110 ermittelt die Funktion J, während der untere Schaltungsteil 120 die Funktion K ermittelt. Die einzelnen Widerstände R2, R3, R4, R8, R9, R10, R11, R12, R13, R14 und R24 der Operationsverstärkerschaltungen werden so dimensioniert, dass die Spannungspegel der Eingangssignale und der erwünschte Spannungspegel des Ausgangssignals berücksichtigt werden.

In dem in Fig. 1 dargestellten Ausführungsbeispiel haben die Widerstände R2, R3, R4, R8, R9, R10, R11, R12, R13, R14 und R24 jeweils einen Wert von 1 kΩ und die Dioden D1, D2, D5 und D6 sind vom Typ D1N1002.

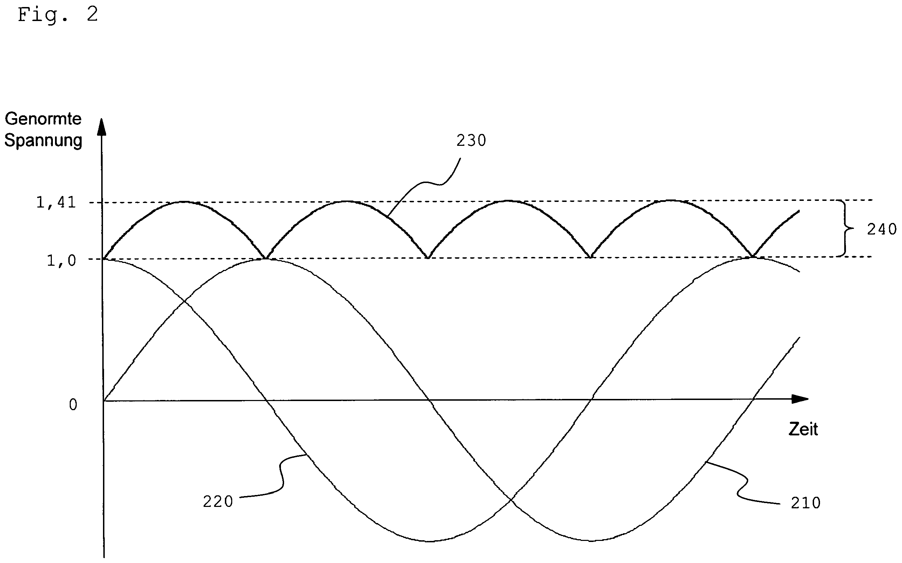

In Fig. 2 sind die Spannungsverläufe 210 und 220 der an den Signaleingängen A und B im Normalbetrieb des Inkrementalencoders anliegenden Eingangssignale A und B, sowie der sich ergebende Spannungsverlauf 230 des am Punkt V vorliegenden Ausgangssignals der in Fig. 1 dargestellten Schaltungsanordnung dargestellt. Aufgrund der Abhängigkeit der Eingangssignale schwankt das Ausgangssignal in einem definierten Wertebereich 240 zwischen 1,0 und 1,41, bei entsprechender Normierung der Spannungswerte.

Für die Überwachung auf Fehler gilt nun: Am Ausgang V der Schaltung muss ein konstantes Signal vorliegen, welches kontinuierlich um maximal 18% schwankt - unabhängig von der Rotationsgeschwindigkeit des Encoders. Treten Fehler auf, so wird der Spannungspegel am Ausgang, d.h. am Messpunkt V, verfälscht und der Fehler somit erkannt, beispielsweise mittels eines Fensterkomparators.

Die in Fig. 1 dargestellte Schaltungsanordnung lässt sich besonders vorteilhaft zur Signalprüfung von sin/cos-Signalspuren eines Inkrementalgebers einsetzen und ermöglicht den Einsatz in einer Überwachungsvorrichtung zur Prüfung der Signalspuren auf Fehler. Aufgrund der verwendeten analogen Schalttechnik kann zudem besonders vorteilhaft eine diversitär ausgelegte Überwachungsvorrichtung bereitgestellt werden, wobei durch die Erfindung ein deutlich geringerer schaltungstechnischer Aufwand für die analoge Schaltung erforderlich ist, als bei aus dem Stand der Technik bekannte Lösungen.

Die Erfindung ist jedoch nicht auf die nur exemplarisch beschriebenen Signalprüfung von Inkrementalgebern beschränkt, sondern läst sich vielmehr allgemein für die Prüfung von Signalen einsetzen, welche im Normalbetrieb einer auf Fehler zu prüfenden Vorrichtung in bekannter Weise voneinander abhängen.

## Patentansprüche

1. Verfahren zur Signalprüfung wenigstens eines ersten und zweiten analogen Eingangssignals (210, 220), welche von einer elektrischen Vorrichtung bereitgestellt werden und welche im Normalbetrieb der Vorrichtung derart voneinander abhängen, dass ein mittels einer vorgegebenen ersten Vorschrift aus dem wenigstens einen ersten und zweiten analogen Signal ermittelbares erstes Ausgangssignal im Wesentlichen zeitlich konstant ist, mit den Schritten:
- Definieren einer zweiten Vorschrift zum Ermitteln eines zweiten Ausgangssignals (230) aus dem wenigstens einen ersten und zweiten analogen Eingangssignal (210, 220), welches zeitlich innerhalb eines vorgegebenen Wertebereiches (240) schwankt,
- Bereitstellen einer analogen Schaltungsanordnung (100), welche die zweite Vorschrift abbildet, mit wenigstens einem ersten Signaleingang (A) für das erste und einem zweiten Signaleingang (B) für das zweite analoge Eingangssignal und einem Ausgang (V) zum Bereitstellen des auf Basis der zweiten Vorschrift durch die Schaltungsanordnung (100) erzeugten Ausgangssignals (230), umfassend
- einen ersten Schaltungsteil (110), welcher zum Addieren der positiven Spannungsanteile des ersten und zweiten Eingangssignals (210, 220) ausgebildet ist,
- einen zweiten Schaltungsteil (120), welcher zum Addieren der negativen Spannungsanteile des ersten und zweiten Eingangssignals (210, 220) ausgebildet ist, und
- einen mit dem ersten (110) und zweiten (120) Schaltungsteil verbundenen dritten Schaltungsteil (130) zum Ermitteln der Differenz der addierten positiven und der addierten negativen Spannungsanteile, wobei der dritte Schaltungsteil (130) ausgangsseitig als Ausgangssignal (230) das Prüfsignal bereitstellt,
- Zuführen des wenigstens einen ersten und zweiten analogen Eingangssignals (210, 220) an die zugeordneten Signaleingänge (A, B) der bereitgestellten Schaltungsanordnung (100),
- Auswerten des Ausgangssignals (230) der bereitgestellten Schaltungsanordnung (100),
- Bereitstellen eines positiven Prüfungsergebnisses der Signalprüfung, falls das am Ausgang (V) der Schaltungsanordnung (100) anliegende Ausgangssignal (230) innerhalb des vorgegebenen Wertebereiches (240) liegt, und
- Bereitstellen eines negativen Prüfungsergebnisses der Signalprüfung, falls das am Ausgang (V) der Schaltungsanordnung anliegende Ausgangssignal (230) zumindest zeitweise außerhalb des vorgegebenen Wertebereiches (240) liegt.

2. Verfahren nach Anspruch 1, wobei die erste Vorschrift eine Berechnungsvorschrift ist, welche wenigstens einen quadratischen Term umfasst.

3. Verfahren nach Anspruch 1 oder 2, wobei die zweite Vorschrift eine Berechnungsvorschrift ist, welche keinen quadratischen Term umfasst.

4. Verfahren nach einem der vorstehenden Ansprüche, wobei die erste Vorschrift die Berechnungsvorschrift f₁(A,B)=A²+B² und die zweite Vorschrift die Berechnungsvorschrift f₂(A,B)=|A|+|B| ist, wobei A für das erste Eingangssignal und B für das zweite Eingangssignal steht.

5. Verfahren nach einem der vorstehenden Ansprüche, wobei im Normalbetrieb der elektrischen Vorrichtung das erste Eingangssignal ein Sinus-Signal und das zweite Eingangssignal ein dazu um 90° phasenverschobenes Cosinus-Signal ist, wobei das erste und zweite Eingangssignal insbesondere von einem Inkrementalgeber bereitgestellt werden.

6. Schaltungsanordnung (100) zum Erzeugen eines Prüfsignals (230) aus wenigstens einem ersten (210) und einem zweiten (220) von einer elektrischen Vorrichtung bereitgestellten analogen Eingangssignals, wobei die Schaltungsanordnung (100) dazu ausgebildet ist, ein Prüfsignal (230) zu erzeugen, welches im Normalbetrieb der elektrischen Vorrichtung zeitlich innerhalb eines vorgegebenen Wertebereiches (240) schwankt, umfassend
- einen ersten Schaltungsteil (110), welcher zum Addieren der positiven Spannungsanteile des ersten und zweiten Eingangssignals (210, 220) ausgebildet ist,
- einen zweiten Schaltungsteil (120), welcher zum Addieren der negativen Spannungsanteile des ersten und zweiten Eingangssignals (210, 220) ausgebildet ist, und
- einen mit dem ersten (110) und zweiten (120) Schaltungsteil verbundenen dritten Schaltungsteil (130) zum Ermitteln der Differenz der addierten positiven und der addierten negativen Spannungsanteile, wobei der dritte Schaltungsteil (130) ausgangsseitig das Prüfsignal (230) bereitstellt.

7. Schaltungsanordnung nach Anspruch 6, wobei das wenigstens eine erste und zweite Eingangssignal (210, 220) im Normalbetrieb der elektrischen Vorrichtung derart voneinander abhängen, dass ein mittels einer vorgegebenen ersten Vorschrift aus den wenigstens zwei analogen Signalen ermittelbares erstes Ausgangssignal im Wesentlichen zeitlich konstant ist.

8. Schaltungsanordnung nach einem der Ansprüche 6 oder 7, wobei im Normalbetrieb der elektrischen Vorrichtung das erste Eingangssignal (210) ein Sinus-Signal und das zweite Eingangssignal (220) ein dazu um 90° phasenverschobenes Cosinus-Signal ist, wobei das erste und zweite Eingangssignal insbesondere von einem Inkrementalgeber bereitgestellt werden.

9. Schaltungsanordnung nach einem der Ansprüche 6 bis 8, welche ausschließlich Bauteile der analogen Schalttechnik umfasst.

10. Schaltungsanordnung nach einem der Ansprüche 6 bis 9, wobei von der elektrischen Vorrichtung wenigstens zwei erste und zweite Eingangsignale bereitgestellt werden, und wobei die Schaltungsanordnung einen dem ersten und zweiten Schaltungsteil vorgeschalteten Schaltungsteil zur Signalvorverarbeitung umfasst, welcher dazu ausgebildet ist, aus den wenigstens zwei ersten und zweiten Eingangsignalen das genau eine erste und zweite Eingangsignal zu erzeugen.

11. Überwachungsvorrichtung, umfassend
- eine analoge Schaltungsanordnung (100) zum Erzeugen eines ersten Prüfsignals (230) aus einem ersten (210) und einem zweiten (220) von einer elektrischen Vorrichtung erzeugten Eingangssignals nach einem der Ansprüche 6 bis 10, und
- eine Überwachungseinheit zum Überwachen des ersten Prüfsignals (230), dazu ausgebildet, ein Fehlersignal zu erzeugen, wenn das erste Prüfsignal (230) einen Signalwert aufweist, der außerhalb eines vorgegebenen Wertebereiches (240) liegt.

12. Überwachungsvorrichtung nach Anspruch 11, wobei die Überwachungseinheit dazu ausgebildet ist, das erste Prüfsignal (230) mit einem unteren und/oder einem oberen Schwellwert zu vergleichen.

13. Überwachungsvorrichtung nach einem der Ansprüche 11 oder 12, ferner umfassend eine digitale Schaltung zum Erzeugen eines zweiten Prüfsignals aus dem ersten und zweiten Eingangssignal.

## Claims

1. A method for signal testing of at least a first and a second analogue input signal (210, 220) which are provided by an electrical device and which during normal operation of the device depend on one another such that a first output signal that can be determined from the at least one first and second analogue signals using a predetermined first rule is substantially constant over time, comprising the steps of:
- defining a second rule for determining a second output signal (230) from the at least one first and second analogue input signals (210, 220), which varies over time within a predetermined value range (240);
- providing an analogue circuit arrangement (100) implementing the second rule, which comprises at least a first signal input (A) for the first and a second signal input (B) for the second analogue input signals and an output (V) for providing the output signal (230) generated by the circuit arrangement (100) on the basis of the second rule; comprising
- a first circuit part (110) adapted to add the positive voltage portions of the first and second input signals (210, 220);
- a second circuit part (120) adapted to add the negative voltage portions of the first and second input signals (210, 220); and
- a third circuit part (130) connected to the first (110) and second (120) circuit parts for determining the difference between the added positive and added negative voltage portions, the third circuit part (130) providing the test signal as the output signal (230) on the output side;
- feeding the at least one first and second analogue input signals (210, 220) to the associated signal inputs (A, B) of the provided circuit arrangement (100);
- evaluating the output signal (230) of the provided circuit arrangement (100);
- providing a positive test result of the signal test, if the output signal (230) present at the output (V) of the circuit arrangement (100) is within the predetermined value range (240); and
- providing a negative test result of the signal test, if the output signal (230) present at the output (V) of the circuit arrangement is at least temporarily outside the predetermined value range (240).

2. The method according to claim 1, wherein the first rule is a calculation rule including at least one quadratic term.

3. The method according to claim 1 or 2, wherein the second rule is a calculation rule that does not include a quadratic term.

4. The method according to any one of the preceding claims, wherein the first rule is the calculation rule f₁(A,B) = A² + B², and the second rule is the calculation rule f₂(A,B) = |A| + |B|, wherein A represents the first input signal and B represents the second input signal.

5. The method according to any one of the preceding claims, wherein during normal operation of the electrical device, the first input signal is a sine signal and the second input signal is a cosine signal phase-shifted by 90° thereto, wherein the first and second input signals are in particular provided by an incremental encoder.

6. A circuit arrangement (100) for generating a test signal (230) from at least a first (210) and a second (220) analogue input signal provided by an electrical device, wherein the circuit arrangement (100) is adapted to generate a test signal (230) which during normal operation of the electrical device varies over time within a predetermined values range (240); comprising
- a first circuit part (110), adapted to add the positive voltage portions of the first and second input signals (210, 220);
- a second circuit part (120), adapted to add the negative voltage portions of the first and second input signals (210, 220); and
- a third circuit part (130) connected to the first (110) and second (120) circuit parts for determining the difference between the added positive and added negative voltage portions, the third circuit part (130) providing the test signal (230) on the output side.

7. The circuit arrangement according to claim 6, wherein during normal operation of the electrical device the at least one first and second input signals (210, 220) depend on one another such that a first output signal which can be determined from the at least two analogue signals using a predetermined first rule is substantially constant over time.

8. The circuit arrangement according to any one of claims 6 or 7, wherein during normal operation of the electrical device, the first input signal (210) is a sine signal and the second input signal (220) is a cosine signal phase-shifted by 90° thereto, wherein the first and second input signals are in particular provided by an incremental encoder.

9. The circuit arrangement according to any one of claims 6 to 8, comprising exclusively analogue circuit technology components.

10. The circuit arrangement according to any one of claims 6 to 9, wherein the electrical device provides at least two first and second input signals, and wherein the circuit arrangement comprises a circuit part upstream the first and second circuit parts, for signal preprocessing, which is adapted to produce said exactly one first and one second input signal from said at least two first and second input signals.

11. A monitoring device, comprising
- an analogue circuit arrangement (100) for generating a first test signal (230) from a first (210) and a second (220) input signal according to claims 6 to 10, generated by an electrical device; and
- a monitoring unit for monitoring the first test signal (230), adapted to generate an error signal when the first test signal (230) has a signal value which is outside of a predetermined value range (240).

12. The monitoring device according to claim 11, wherein the monitoring unit is adapted to compare the first test signal (230) with a lower and/or an upper threshold value.

13. The monitoring device according to any one of claims 11 or 12, further comprising a digital circuit for generating a second test signal from the first and second input signals.

## Revendications

1. Procédé de contrôle de signaux d'au moins un premier et un deuxième signal d'entrée analogique (210, 220), lesquels sont fournis par un dispositif électrique et lesquels, lors d'un fonctionnement normal du dispositif, dépendent l'un de l'autre de telle manière qu'un premier signal de sortie pouvant être déterminé à partir de l'au moins un premier et deuxième signal analogique au moyen d'une première règle prédéfinie est sensiblement constant, le procédé comprenant les étapes consistant :
- à définir une deuxième règle pour la détermination d'un deuxième signal de sortie (230) à partir de l'au moins un premier et deuxième signal d'entrée analogique (210, 220), lesquels fluctuent dans le temps à l'intérieur d'une plage de valeurs (240) prédéfinie,
- à fournir un circuit analogique (100), lequel reproduit la deuxième règle, avec au moins une première entrée de signal (A) pour le premier signal d'entrée analogique et une deuxième entrée de signal (B) pour le deuxième signal d'entrée analogique et une sortie (V) pour la fourniture du signal de sortie (230) produit par le circuit (100) sur la base de la deuxième règle, le circuit comprenant :
- une première partie de circuit (110), laquelle est conçue pour ajouter les parties positives de tension des premier et deuxième signaux d'entrée (210, 220),
- une deuxième partie de circuit (120), laquelle est conçue pour ajouter les parties négatives de tension des premier et deuxième signaux d'entrée (210, 220), et
- une troisième partie de circuit (130) reliée à la première (110) et à la deuxième partie de circuit (120) pour déterminer la différence entre les parties positives de tension ajoutées et les parties négatives de tension ajoutées, la troisième partie de circuit (130) fournissant côté sortie le signal de contrôle en tant que signal de sortie (230),
- à amener l'au moins un premier et deuxième signal d'entrée analogique (210, 220) aux entrées de signal (A, B) associées du circuit (100) fourni,
- à évaluer le signal de sortie (230) du circuit (100) fourni,
- à fournir un résultat de contrôle positif du contrôle de signaux, au cas où le signal de sortie (230) s'appliquant contre la sortie (V) du circuit (100) se situerait à l'intérieur de la plage de valeurs (240) prédéfinie, et
- à fournir un résultat de contrôle négatif du contrôle de signaux, au cas où le signal de sortie (230) s'appliquant contre la sortie (V) du circuit se situerait au moins temporairement à l'extérieur de la plage de valeurs (240) prédéfinie.

2. Procédé selon la revendication 1, la première règle étant une règle de calcul comportant au moins un terme quadratique.

3. Procédé selon la revendication 1 ou 2, la deuxième règle étant une règle de calcul ne comportant aucun terme quadratique.

4. Procédé selon l'une quelconque des revendications précédentes, la première règle étant la règle de calcul f₁(A,B)=A²+B² et la deuxième règle étant la règle de calcul f₂(A,B)=|A|+|B|, A représentant le premier signal d'entrée et B le deuxième signal d'entrée.

5. Procédé selon l'une quelconque des revendications précédentes, le premier signal d'entrée, lors d'un fonctionnement normal du dispositif électrique, étant un signal sinusoïdal et le deuxième signal d'entrée étant un signal cosinusoïdal déphasé de 90°, le premier et le deuxième signal d'entrée étant fournis en particulier par un codeur incrémental.

6. Circuit (100) destiné à produire un signal de contrôle (230) à partir d'au moins un premier signal d'entrée analogique (210) et un deuxième signal d'entrée analogique (220) fournis par un dispositif électrique, le circuit (100) étant conçu pour produire un signal de contrôle (230), lequel, lors d'un fonctionnement normal du dispositif électrique, fluctue dans le temps à l'intérieur d'une plage de valeurs (240) prédéfinie, comportant :
- une première partie de circuit (110), laquelle est conçue pour ajouter les parties positives de tension des premier et deuxième signaux d'entrée (210, 220),
- une deuxième partie de circuit (120), laquelle est conçue pour ajouter les parties négatives de tension des premier et deuxième signaux d'entrée (210, 220), et
- une troisième partie de circuit (130) reliée à la première (110) et à la deuxième partie de circuit (120) et destinée à déterminer la différence entre les parties positives de tension ajoutées et les parties négatives de tension ajoutées, la troisième partie de circuit (130) fournissant côté sortie le signal de contrôle (230).

7. Circuit selon la revendication 6, l'au moins un premier et deuxième signal d'entrée (210, 220), lors d'un fonctionnement normal du dispositif électrique, dépendant les uns des autres de telle manière qu'un premier signal de sortie, pouvant être déterminé à partir des au moins deux signaux analogiques au moyen d'une première règle prédéfinie, est sensiblement constant.

8. Circuit selon l'une quelconque des revendications 6 ou 7, le premier signal d'entrée (210), lors d'un fonctionnement normal du dispositif électrique, étant un signal sinusoïdal et le deuxième signal d'entrée (220) étant un signal cosinusoïdal déphasé de 90°, le premier et le deuxième signal d'entrée étant fournis en particulier par un codeur incrémental.

9. Circuit selon l'une quelconque des revendications 6 à 8, lequel comporte exclusivement des composants de la technique de commutation analogique.

10. Circuit selon l'une quelconque des revendications 6 à 9, au moins deux premiers et deuxièmes signaux d'entrée étant fournis par le dispositif électrique, et le circuit comportant une partie de circuit qui est montée en amont de la première et de la deuxième partie de circuit, qui est destinée au prétraitement des signaux et qui est conçue pour produire le seul premier et le seul deuxième signal d'entrée à partir des au moins deux premiers et deuxièmes signaux d'entrée.

11. Dispositif de surveillance, comportant :
- un circuit analogique (100) pour la production d'un premier signal de contrôle (230) à partir d'un premier (210) et d'un deuxième signal d'entrée (220) produits par un dispositif électrique selon l'une quelconque des revendications 6 à 10, et
- une unité de surveillance pour la surveillance du premier signal de contrôle (230), conçue pour produire un signal d'erreur lorsque le premier signal de contrôle (230) présente une valeur de signal qui se situe à l'extérieur d'une plage de valeurs (240) prédéfinie.

12. Dispositif de surveillance selon la revendication 11, l'unité de surveillance étant conçue pour comparer le premier signal de contrôle (230) à une valeur seuil inférieure et/ou supérieure.

13. Dispositif de surveillance selon l'une quelconque des revendications 11 ou 12, comprenant en outre un circuit numérique pour la production d'un deuxième signal de contrôle à partir du premier et deuxième signal d'entrée.
